(19) Europäisches Patentamt
European Patent Office
Office européen des brevets

(11) EP 0 808 823 A1

(12) EUROPEAN PATENT APPLICATION

(43) Date of publication:
**26.11.1997 Bulletin 1997/48**

(51) Int. Cl.[6]: **C07C 69/60**, C07C 69/593

(21) Application number: **97201941.8**

(22) Date of filing: **07.03.1990**

(84) Designated Contracting States:
**AT BE CH DE FR GB IT LI LU NL SE**

(30) Priority: **07.03.1989 US 319566**
**08.09.1989 US 404578**
**15.11.1989 US 437374**

(62) Document number(s) of the earlier application(s) in accordance with Art. 76 EPC:
**90905063.5 / 0 462 204**

(71) Applicant: **DSM N.V.**
**6411 TE Heerlen (NL)**

(72) Inventors:
- **Krajewski, John J.**
**Wheeling, Illinois 60090 (US)**
- **Noren, Gerry K.**
**Hoffman Estates, Illinois 60195 (US)**
- **Zimmerman, John M.**
**Hoffman Estates, Illinois 60195 (US)**
- **Shama, Sami A.**
**Hoffman Estates, Illinois 60195 (US)**

Remarks:
- This application was filed on 25 - 06 - 1997 as a divisional application to the application mentioned under INID code 62.
- The application is published incomplete as filed (Article 93 (2) EPC). Originally filed page 45 is blank and the point in the description at which the omission obviously occurs has been left blank.

# (54) Free-radical curable compositions

(57) A dual functional monomer having the Formula:

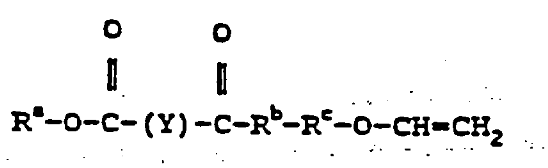

wherein $R^a$ is selected from the group consisting of H, $C_1$ to $C_{10}$ alkyl or allyl groups, $C_5$ to $C_{10}$ aryl group, metal ions, heteroatoms and combinations of carbon and heteroatoms; $R^b$ is absent or selected from the group consisting of O, $C(R^a)_2$, heteroatoms, or substituted heteroatoms; $R^c$ is an aliphatic, branched or cyclic alkyl group or an arylalkyl group that contains 1 to about 10 carbon atoms, and can contain heteroatoms; and Y is selected from the group consisting of:

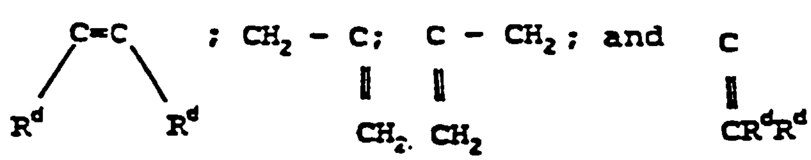

wherein each $R^d$ is independently selected from the group consisting of H, $C_1$ to $C_4$ alkyl groups, $C_5$ to $C_{10}$ aryl groups and electron withdrawing groups.

EP 0 808 823 A1

## Description

### Technical Field

This invention is directed to a dual functional monomer and to free-radical curable compositions that are useful as coatings for various substrates, comprising a dual functional monomer.

### Background of the Invention

There are many applications that require a rapidly curable coating composition that adheres to a substrate, is flexible, does not discolor and has low toxicity. For example, optical glass fibers are frequently coated with two superposed coatings. The coating which contacts the glass is a relatively soft, primary coating that must satisfactorily adhere to the fiber and be soft enough to resist microbending especially at low service temperatures. The outer, exposed coating is a much harder secondary coating that provides the desired resistance to handling forces yet must be flexible enough to enable the coated fiber to withstand repeated bending without cracking the coating.

Other applications, e.g., optical fabrication, coatings for substrates including glass, metal, wood, plastic, rubber, paper, concrete, and fabrics, and adhesives also require compositions that are fast curing, have low toxicity, and provide good physical properties.

Compositions that include (meth)acrylate diluents have been utilized for many of these applications. However, (meth)acrylate diluents are hazardous to human health. Therefore, it is desirable to eliminate or reduce the amount of (meth)acrylate diluents present in a composition.

Vinyl ether compositions have been utilized as replacements for (meth)acrylates. Although vinyl ethers rapidly cure when exposed to ultraviolet light in the presence of a cationic curing catalyst, their cure under cationic conditions leaves catalyst residues that discolor the cured compositions and cause them to be sensitive to water. Furthermore, vinyl ether containing oligomers having relatively high equivalent weights, e.g., an equivalent weight in excess of about 500, do not cationically cure upon exposure to dosages of energy less than 3 Joules per square centimeter. Vinyl ethers do not homopolymerize in the presence of free radical initiators. Therefore, vinyl ethers are not suitable replacements for (meth)acrylates.

Unsaturated polyesters, e.g., maleates and fumarates, are known to be substantially non-toxic, but are unsatisfactory as replacements for (meth)acrylates because their rate of cure when exposed to ultraviolet light is not satisfactory for certain applications.

European Patent Application No. 0 322 808 published on 05.07.89 discloses a radiation curable composition that comprises an ethylenically unsaturated polyester component and a vinyl ether component having an average of at least two vinyl ether groups per molecule of the vinyl ether component. The unsaturated polyester component can be a polymer, oligomer or mixture thereof. Coatings produced from this composition are brittle and hard because of the large amount of electron deficient ethylenically unsaturated groups in the backbone of the polyester component which leads to short chain segments between cross-links. The vinyl ether component reacts with the ethylenically unsaturated group and results in a high degree of cross-linking that causes the cured composition to be brittle, inflexible and hard. Thus, coatings produced from the composition of this European Patent Application do not possess the needed flexibility and softness for applications, such as optical glass fiber coatings, that require a flexible and soft coating.

### Summary of the Invention

The invention of the basic application is directed to free-radical curable compositions comprising

1a) 0 to 80 weight %, based on the total weight of the composition, of an oligomer having a number average molecular weight of 500-8000 containing at least one vinyl ether group, linked to a saturated backbone,
and
1b) 20 to 80 weight %, based on the total weight of the composition, of a polyester comprising a saturated polyester backbone and at least one ethylenically unsaturated dicarboxylate end group per molecule of polyester,
and
2) at least one of
2a) a single functionality diluent containing either at least one vinyl ether group or at least one ethylenically unsaturated dicarboxylate group,
2b) a mixture of single functionality diluents or
2c) a dual functional monomer containing at least one vinyl ether group and at least one ethylenically unsaturated dicarboxylate group,
wherein the ratio of vinyl ether groups to ethylenically unsaturated dicarboxylate groups in the composition is in the range of 5:1 to 1:5; and wherein each of said ethylenically unsaturated dicarboxylate groups has an electron deficient ethylenically unsaturated double bond.

These compositions exhibit low toxicity, good cure speeds, good physical properties and are readily synthesized and economical to produce.

The single functionality diluent can contain either electron deficient unsaturated dicarboxylate groups or vinyl ether groups. The dual functional monomer preferably contains at least one electron deficient unsaturated dicarboxylate group and a vinyl ether group.

The components of the composition are selected to achieve the desired ratio of vinyl ether double bonds to electron deficient double bonds in the composition.

The present invention is directed to dual functional monomers. The dual functional monomers can be incorporated in the compositions of the basic invention instead of, or in addition to the single functionality diluent. This dual functional monomer can be represented by the Formula I:

(I) 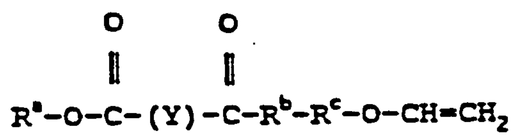

wherein $R^a$ is selected from the group consisting of H, $C_1$ to $C_{10}$ alkyl or allyl groups, $C_5$ to $C_{10}$ aryl groups, metal ions, heteroatoms and combinations of carbon and heteroatoms; $R^b$ is absent or selected from the group consisting of O, $C(R^a)_2$, heteroatoms or substituted heteroatoms; $R^c$ is an aliphatic, branched or cyclic alkyl group or an arylalkyl group that contains 1 to 10 carbon atoms, and can contain heteroatoms; and Y is selected from the group consisting of:

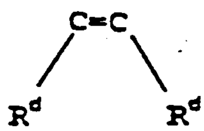 ; 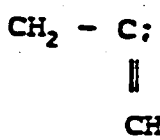 ; 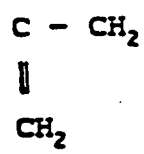 ; and 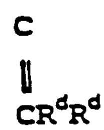

wherein each $R^d$ is independently selected from the group consisting of H, $C_1$ to $C_4$ alkyl groups, $C_5$ to $C_{10}$ aryl groups and electron withdrawing groups.

These dual functional monomers can be polymerized as homopolymers, copolymers or random polymers with other monomers by conventional polymerization techniques. However, it is preferred to formulate these dual functional monomers in the compositions of the basic invention.

The compositions of the present invention are curable upon exposure to ionizing radiation, actinic energy and heat.

Thus, the present invention provides compositions having many properties desired by industry while overcoming the shortcomings of the prior art.

## Detailed Description of Preferred Embodiments

The invention is directed to a dual functional-monomer and to free-radical curable compositions that comprise at least one dual functional monomer.

The term "vinyl ether", in its various grammatical forms, refers to a vinyl group bound to an oxygen atom which is bound to a carbon atom.

The term "single functionality diluent" as used in its various grammatical forms, defines a diluent having only one type of reactive group, e.g., a vinyl ether group or an electron deficient ethylenically unsaturated dicarboxylate group such as a maleate on the same molecule of diluent. However, this diluent can be polyfunctional, i.e., a molecule can have more than one reactive group provided all reactive groups are of the same type. An admixture of diluents can contain vinyl ether groups and electron deficient dicarboylate groups.

The term "dual functional monomer", as used herein, defines a monomer having at least one vinyl ether group and at least one electron deficient ethylenically unsaturated dicarboxylate group. The ratio of vinyl ether groups to electron deficient groups in the monomer can be selected to achieve the desired ratio of vinyl ether double bonds to electron deficient double bonds in the composition.

The vinyl ether containing oligomers can be produced by conventionally reacting a vinyl ether having either a hydroxyl group or amine group with a saturated backbone containing component. The saturated backbone containing component is represented by the reaction product of saturated hydroxy functional polyesters, polycarbonates, polycaprolactones, polyethers, Bisphenol-A alkoxylates, siloxanes, or polyethers, with organic polyisocyanates, the like and mixtures thereof. The backbone of the vinyl ether containing oligomer can contain repeating units. The group linking the vinyl ether group to the saturated backbone (linking group) can be a urethane, urea, ester, ether, or thio group and the like. Preferred linking groups are urethane, urea and ester groups. Mixtures of linking groups can be used.

Representative of the vinyl ethers suitable as reactants in the production of the vinyl ether containing oligomer are conventional hydroxy functional vinyl ethers including triethylene glycol monovinyl ether, 1,4-cyclohexane dimethylol monovinyl ether and 4-hydroxy butylvinyl ether.

Representative of the saturated polyesters are the reaction products of saturated polycarboxylic acids, or their anhydrides, and diols. Suitable saturated polycarboxylic acids and anhydrides include phthalic acid, isophthalic acid, terephthalic acid, trimellitic acid, tetrahydrophthalic acid, hexahydrophthalic acid, tetrachlorophthalic acid, adipic acid, azelaic acid, sebacic acid, succinic acid, glutaric acid, malonic acid, pimelic acid, suberic acid, 2,2-dimethylsuccinic acid, 3,3-dimethylglutaric acid, 2,2-dimethylglutaric acid, the like, anhydrides thereof and mixtures thereof. Suitable diols include 1,4-butane diol, 1,8-octane diol and the like.

Representative of the saturated polycarbonates are polyhexamethylene carbonate commercially available from PPG Industries under the trade designation Duracarb 120 and polycyclohexane dimethylene carbonate commercially available from PPG Industries under the trade designation Duracarb 140.

Representative of the saturated polyethers are polyalkylene oxides, alkyl substituted poly(tetrahydrofurans), and copolymers of the alkyl substituted tetrahydrofurans and a cyclic ether.

Representative of the polyalkylene oxides are poly(propylene oxide), commercially available from Union Carbide under the trade designation Niax PPG 1025 and poly(tetramethylene glycol), commercially available from DuPont under the trade designation Terathane 1000.

The alkyl substituted poly(tetrahydrofurans) have ring structures that open during polymerization. The alkyl group of the alkyl substituted poly(tetrahydrofurans) has 1 to 4 carbon atoms. Representative of the alkyl substituted poly(tetrahydrofurans) are poly(2-methyltetrahydrofuran) and poly(3-methyltetrahydrofuran). Representative of the cyclic ethers with which the alkyl substituted tetrahydrofurans can be copolymerized are ethylene oxide, propylene oxide, tetrahydrofuran and the like.

Representative of the polycaprolactones are the Tone Polyol series of products, e.g., Tone 0200, 0221, 0301, 0310, 2201, and 2221, commercially available from Union Carbide, New York, NY. Tone Polyol 0200, 0221, 2201, and 2221 are difunctional. Tone Polyol 0301 and 0310 are trifunctional.

Representative of the Bisphenol-A alkoxylates are those wherein the alkoxy group contains about 2 to about 4 carbon atoms, e.g., ethoxy. A commercial Bisphenol-A alkoxylate is the Bisphenol-A diethoxylate available under the trade designation Dianol 22 from Akzo Research, The Netherlands.

Representative of the siloxanes is poly(dimethylsiloxane) commercially available from Dow Corning under the trade designation DC 193.

The oligomer containing vinyl ether groups can be the reaction product of an organic polyisocyanate, preferably a diisocyanate (especially a diphenylalkane diisocyanate in which the alkane group contains 1 to 8 carbon atoms), and a transvinylated polyhydric alcohol mixture containing hydroxy groups that is the transvinylation reaction product of (1) at least one vinyl ether and (2) at least one polyhydric alcohol having an average of more than 2 hydroxy groups per molecule. The polyisocyanate is present in an amount sufficient to consume substantially all of the available hydroxy groups in the transvinylation mixture.

The term "transvinylation", as used in its various grammatical forms, means that the vinyl ether group of the vinyl ether and the hydroxy group of the alcohol are exchanged.

The terms "transvinylation mixture" and "transvinylation polyhydric alcohol mixture", as used in their various grammatical forms, mean unreacted polyhydric alcohol, partially transvinylated polyhydric alcohol and fully transvinylated polyhydric alcohol are present in the transvinylation reaction product of the vinyl ether and the polyhydric alcohol. The transvinylation mixture is preferably, but not necessarily, an equilibrium mixture.

The term "substantially all", in its various grammatical forms, when used in reference to the isocyanate consuming the hydroxy groups (hydroxy functionality), means that if the vinyl ether containing oligomer has hydroxy groups available to form acetal groups, they are not present in an amount that adversely affects the properties of the compositions.

The transvinylated aliphatic polyhydric alcohol mixture can contain partially vinylated polyhydric alcohols and at least 3 percent to 90 percent by weight of unreacted polyhydric alcohols. The polyisocyanate consumes substantially all of the available hydroxy functionality. Simple monohydric alcohols (which are formed when a $C_1$ to $C_4$ alkyl vinyl ether is used) are preferably removed to provide a transvinylation mixture that is substantially free of simple monohydric alcohols. Such alcohols function to terminate the vinyl ether containing oligomer which is formed, an action that is undesirable, but tolerable in some instances.

The term "simple monohydric alcohol", as used in its various grammatical forms, refers to a short chain alcohol containing 1 to 4 carbon atoms and having only one hydroxy group per molecule.

The transvinylated mixture is produced by transvinylating a vinyl ether with at least one polyhydric alcohol that preferably contains an average of more than 2 hydroxy groups per molecule, whereafter any simple monohydric alcohol by-product of the transvinylation reaction and the transvinylation catalyst are normally removed. More particularly, the vinyl ether containing oligomers are prepared from the transvinylation reaction product of an arylalkyl polyhydric alcohol, which most preferably contains or consists of polyhydric alcohols having on average of 3 or more hydroxy groups per molecule, and a vinyl ether that can contain one or more vinyl ether groups per molecule. The transvinylated reaction product contains partially transvinylated polyhydric alcohols as well as unreacted polyhydric alcohols, and it can also contain fully transvinylated polyhydric alcohols.

The transvinylation reaction is conveniently carried out in the presence of a catalyst that is known for use in this reaction. While it is not essential, the catalyst and the simple monohydric alcohol by-products of the reaction can both be optionally removed, and this usually also removes any unreacted monovinyl ether which may be present.

It is desired to point out that the catalyst is conventionally removed by filtration, which is a particularly simple operation. Any simple monohydric alcohols and any unreacted monovinyl ether which can be present when a monovinyl ether is used in the transvinylation reaction are highly volatile and easily removed by evaporation from the reaction product, leaving the balance of the transvinylation reaction product intact. This method of operation eliminates the need to distill off the monohydric vinyl ether utilized in conventional compositions, and other components that are distilled off with this monohydric vinyl ether, from the potassium hydroxide catalyst used in the reaction with acetylene. The distillation step utilized in the prior art is a difficult operation involving elevated temperature which causes undesired side reactions.

Filtration by a chromatography procedure is a representative method of removing the catalyst. In this procedure a 5 inch by 1.5 inch silica gel column (70 to 230 U.S. Sieve Series mesh and having a pH neutral surface) has a 0.5 inch layer of activated carbon placed thereon. The carbon is commercially available from Darco under the trade designation G-60 and passes through a 100 U.S. Sieve Series mesh. The column is wetted with triethylene glycol divinyl ether then the catalyst containing transvinylation mixture is poured through the column. The first 100 milliliters (ml) of eluent are discarded and the remaining eluent is collected as the transvinylation mixture.

The catalyst utilized herein is a conventional transvinylation catalyst and is illustrated by the elements of Groups IB, IIB, IVB, VB, VIB, VIIB, and VIII of the Periodic Table of Elements. Representative catalysts include palladium, mercury, copper, zinc, magnesium, cobalt, mercuric acetate, mercury (II) salts, lithium chloropalladite (I) dialkylpyridines, phosphates of thallium, vanadium, chromium, manganese, iron, cobalt, nickel, Group VI oxyacid salts and mixtures thereof. A presently preferred catalyst is palladium (II).

The catalyst used herein can be a finely divided powder and can be removed by filtration. The addition of charcoal to the transvinylation mixture can assist the filtration process, e.g., when a finely divided powder form of the catalyst is utilized. The simple monohydric alcohol and any volatile alkyl monovinyl ether which is present when an alkyl monovinyl ether is used for transvinylation is preferably removed by vaporization, and this is conveniently performed when methyl or ethyl vinyl ethers are used by applying a reduced pressure to the reaction product at room temperature, i.e., a temperature of 20° to 30°C. It is desired to restrict the purification operation to simple filtration, and this is done herein by using a polyvinyl ether, such as a divinyl ether of a diol illustrated by triethylene glycol divinyl ether, as a transvinylation reactant.

The catalyst can be bound to a solid matrix such as charcoal, nickel, alumina, ion exchange resins, molecular sieves, zeolites, or similar materials. The solid matrix having catalyst bound thereto can be in the shape of beads, filings, part of the walls of a column, and the like. Alternatively, the solid matrix having catalyst bound thereto can be packed in a column.

The product of the transvinylation reaction is a mixture containing partially transvinylated polyhydric alcohols. Accordingly, there is present on these partially transvinylated polyhydric molecules at least one vinyl ether group and at least one hydroxy group, so the transvinylation mixture tends to deteriorate with time and exposure to elevated temperature, at least partially by the formation of acetal groups. Reaction with a polyisocyanate in accordance with this invention significantly reduces the hydroxy content to minimize or largely avoid this deterioration. Prior to reaction with polyisocyanate, the present transvinylation mixture does not require an elevated temperature distillation operation. The elimination of this distillation operation further minimizes this deterioration of the transvinylation mixture.

The transvinylation mixture will normally contain some unreacted polyhydric alcohols and some fully vinylated polyvinyl alcohols, as previously indicated, and these are not removed. This introduces an important economy at the same time that it enables one to increase the molecular weight and the vinyl ether functionality by reaction of the transvinylation mixture with organic polyisocyanates. Increased molecular weight, the presence of internal urethane or urea groups, and the increased vinyl ether functionality all introduce physical toughness into the cured products.

In preferred practice, the partially transvinylated polyhydric alcohols in this invention contain from 3 percent to 25 percent unreacted polyhydric alcohols, 30 to 94 percent partially transvinylated polyhydric alcohols, and from 3 percent to 25 percent fully transvinylated polyhydric alcohols. This is particularly preferred when the polyhydric alcohol that is transvinylated contains 3 or 4 hydroxy groups.

The transvinylation reaction to produce vinyl ethers is itself known, and illustrative articles describing this reaction using alkyl vinyl ethers are, McKeon et al, "The Palladium (II) Catalyzed Vinyl Interchange Reaction - I", Tetrahedron 28:227-232 (1972) and McKeon et al., "The Palladium (II) Catalyzed Vinyl Interchange Reaction - II", Tetrahedron

28:233-238 (1972). However, these articles teach purifying the reaction product and do not suggest the use of a transvinylation mixture.

A method of synthesizing pure vinyl ethers is disclosed in Smith et al., "A Facile Synthesis of Low and High Molecular Weight Divinyl Ethers of Poly(oxyethyrene)", Polymer Preprints 28(2):264-265 (August, 1987). Smith teaches the synthesis of pure vinyl ethers using transetherification chemistry based on the palladium (II) catalysts of poly(oxyethylene) glycols and ethyl vinyl ether.

While the transvinylation mixture can use a diol as the polyhydric alcohol, it preferably employs triols and tetrols (most preferably triols). Indeed, when diols are used some higher functional polyol is preferably added to the mixture that is transvinylated or to the transvinylation mixture that is reacted with the diisocyanate. Suitable higher functional polyols include the triols and higher hydroxy functional polyols referred to herein. Thus, the polyhydric alcohol can be a mixture of alcohols and has an average hydroxy functionality per molecule of more than 2.

Moreover, the transvinylation reaction forms unrefined transvinylation mixtures which are further reacted to enhance stability of the transvinylation mixture by the formation of vinyl ether containing oligomers in which the molecular weight and vinyl ether functionality are both increased.

Suitable polyhydric alcohols for use in this transvinylation reaction can be arylalkyl or aliphatic polyhydric alcohols having an average of more than 2, preferably at least 3, hydroxy groups per molecule on the aliphatic or alkyl portion thereof. It is presently preferred that the polyhydric alcohols have up to about an average of 10 hydroxy groups per molecule.

The polyhydric alcohol utilized is preferably soluble in the vinyl ether and has a number average molecular weight of up to 2,000 daltons. We preferably employ polyhydric alcohols that are liquid at room temperature, i.e., a temperature of 20° to 30° C., or which (if solid) have a number average molecular weight below 400 daltons.

The term "dalton", as used in its various grammatical forms, defines a unit of mass that is $1/12^{th}$ the mass of carbon-12.

The alkyl group of these arylalkyl polyhydric alcohols preferably contains 2 to 10, more preferably 3 to 6, carbon atoms. The aryl group of these polyhydric alcohols preferably contains up to 20, more preferably up to 10, carbon atoms. Illustrative arylalkyl polyhydric alcohols include ethoxylated polyhydric phenols, hydroxy substituted ring structures, e.g., phenol, naphthol, and the like, that are alkoxylated, trimethylol benzene, and the like, and mixtures thereof.

Preferred polyhydric alcohols are aliphatic polyhydric alcohols that contain 2 to 10 carbon atoms, more preferably 3 to 6 carbon atoms, and are illustrated by ethylene glycol, butylene glycol, ester diol, 1,6-hexane diol, glycerol, trimethylol propane, pentaerythritol, and sorbitol. Trimethylol propane is particularly preferred.

The polyhydric alcohol can be a polyether, such as the ethylene oxide or propylene oxide adducts of the polyhydric alcohols noted previously. These are illustrated by the propylene oxide adduct of trimethylol propane that has a number average molecular weight of 1500 daltons.

The polyhydric alcohol can also be a saturated polyester of the polyhydric alcohols noted previously, such as the reaction product of trimethylol propane with epsilon caprolactone having a number average molecular weight of 600 and the reaction product of two moles of ethylene glycol with one mole of adipic acid.

Still other polyhydric alcohols are illustrated by resinous materials that contain hydroxy groups, such as styrene-allyl alcohol copolymers, acrylic copolymers containing 2 percent to 20 percent of copolymerized 2-hydroxyethyl acrylate, and even starch or cellulose. However, these have a higher hydroxy functionality than is now preferred.

The polyhydric alcohol can also be amine substituted, e.g., triethanolamine.

It is desired to stress that the reaction with acetylene utilized in the prior art is not applicable to many of the polyhydric alcohols which are particularly attractive for use in producing the present transvinylation mixture. Polyesters and polycarbonates, such as 1,6-hexane diol polycarbonate having a molecular weight of about 1,000 daltons, are degraded by the potassium hydroxide catalyst used in reaction with acetylene, but can be transvinylated in accordance with this transvinylation process.

Vinyl ethers suitable for use in the transvinylation reaction can be represented by the following general Formula II:

(II) 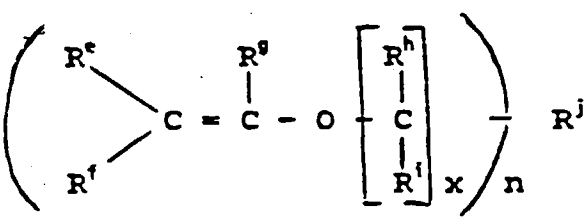

wherein $R^e$, $R^f$, $R^g$, $R^h$, and $R^i$ are each independently selected from the group of hydrogen and lower alkyl groups containing 1 to 4 carbon atoms; $R^e$, or $R^f$, and $R^g$ joined together can be part of a ring structure; $R^e$, or $R^f$, and $R^h$, or $R^i$, joined together can be part of a ring structure; and $R^g$ and $R^h$, or $R^i$, coined together can be part of a ring structure; $R^j$ is an aromatic or aliphatic group that is reactive only at the site(s) where a vinyl ether containing radical is bound; x is

0 or 1; and n is equal to 1 to 10, preferably 1 to 4, with the proviso that n is less than or equal to the number of reactive sites of $R^j$.

$R^j$ can contain heteroatoms, i.e., atoms other than carbon atoms, such as oxygen, nitrogen, sulfur, silicon, phosphorus, and mixtures of heteroatoms alone or in combination with carbon atoms. $R^j$ can contain 1 to 20, preferably 1 to 10, atoms. $R^j$ is preferably a straight or branched carbon containing group containing 1 to 8, more preferably 1 to 4, carbon atoms and can preferably contain oxygen atoms.

Representative of vinyl ethers of Formula II are dihydropyran and dimethylol benzene divinyl ether.

Preferred vinyl ethers for use in the transvinylation reaction can be represented by the following general Formula III:

$$(CH_2 = CH - O - CH_2 )_n R^k \qquad \text{(III)}$$

wherein $R^k$ is an aliphatic group that is reactive only at the site(s) where a vinyl ether containing radical is bound and n is equal to 1 to 4.

$R^k$ contains at least one carbon atom and can contain heteroatoms and mixtures of heteroatoms. Preferably, $R^k$ contains 1 to 4 carbon atoms and can contain oxygen atoms.

Vinyl ethers having the structure of Formula III are illustrated by divinyl ethers, such as 1,4-butane diol divinyl ether, 1,6-hexane diol divinyl ether, and triethylene glycol divinyl ether. Polyvinyl ethers of higher functionality are illustrated by trimethylol propane trivinyl ether and pentaerythritol tetravinyl ether.

Illustrative monovinyl ethers having the structure of Formula III are ethyl vinyl ether, methyl vinyl ether, n-butyl vinyl ether, and the like, including phenyl vinyl ether. The presently preferred monovinyl ether is ethyl vinyl ether which releases ethanol on reaction.

The equivalent ratio of the vinyl ether to the hydroxy groups in the polyhydric alcohol is in the range of 0.5:1 to 5:1, preferably 0.8:1 to 2:1. Possibly of greater significance, the polyhydric alcohol is transvinylated to react with from 10 percent to 90 percent, preferably from 30 percent to 80 percent, of the hydroxy groups which are present thereon. The higher the functionality of the polyhydric alcohol, the higher the proportion of hydroxy groups thereon which should be reacted by transvinylation.

As previously discussed, a palladium (II) catalyst can be utilized. Illustrative palladium catalysts are $PdCl_2$, $(PhCN)_2PdCl_2$, diacetato(2,2'-bipyridyl)palladium (II), diacetato(1,10-phenanthroline)palladium (II), diacetato(N,N,N',N'-tetramethylenediamine)palladium (II), diacetato(P,P,P',P'-tetraphenyl-1,2-diphosphino-ethane) palladium (II); and the like. Diacetato-(1,10-phenanthroline)-palladium (II) is a preferred palladium (II) catalyst.

The catalyst is usually present in a range of 0.001 to 1 percent, preferably about 0.1 percent, by weight based on the total weight of the polyhydric alcohol and vinyl ether.

The transvinylation reaction is a conventional one, as previously indicated, and is described in the articles previously noted. We employ a closed vessel which is charged with the appropriate amounts of the polyhydric alcohol, vinyl ether and catalyst and the mixture is stirred and reacted at a temperature of from about room temperature up to about 45°C. The reaction proceeds slowly, and we usually permit it to proceed for an extended period of time up to about 3 days to obtain the desired equilibrium composition. After about 2 days we find that using a 20 percent stoichiometric excess of vinyl ether with respect to hydroxy functionality causes about half of the hydroxy groups to be consumed in the reaction.

A preferred method of performing the transvinylation reaction is to utilize ultrasonic energy to enhance the transvinylation. In this method an admixture of the vinyl ether, the polyhydric alcohol and the catalyst is exposed to ultrasonic energy for a time period effective to produce the transvinylation mixture. The frequency of the ultrasonic energy is 10 to 850 kilohertz (kHz). The ultrasonic transvinylation reaction is preferably performed at room temperature and pressure, i.e., about one atmosphere.

An illustrative device for supplying ultrasonic energy is a Model B220 ultrasonic cleaner, commercially available from Branson Corp., Shelton, CT. This cleaner has 125 watts of power and provides a frequency of 30 to 50 kHz at this power level. In this method the reactants are placed into a suitable vessel which is then placed in the water bath of the cleaner. The cleaner is then activated to enhance the transvinylation reaction.

The transvinylation reaction can be run for a time period sufficient to obtain the desired transvinylation mixture. A method of determining if the desired transvinylation mixture has been obtained is to test samples by gas chromatography to determine the content of the transvinylation mixture.

After the transvinylation reaction is terminated, it is convenient to remove the catalyst by filtration, and the addition of about 1 percent by weight of charcoal can be helpful. We also prefer to strip off any volatile products which can be present, and this can be done by simply subjecting the reaction product to reduced pressure at room temperature. This removes any residual alkyl monovinyl ether and the simple monohydric alcohol by-product of the reaction, at least when methyl or ethyl vinyl ether is used. With higher monohydric alcohols, modest heat, i.e., heat to achieve a temperature of 30° to 60°C., can be used to help remove volatiles. While the filtration step is preferably carried out prior to removal of volatiles, this sequence can be reversed. When polyvinyl ethers are used, there is no need to subject the transvinylation reaction product to reduced pressure because there is no residual alkyl monovinyl ether or simple monohydric alcohol

by-product present, and this is a feature of this invention.

It is preferred that the transvinylation polyhydric alcohol mixture be liquid at room temperature, but this is not essential since reactive liquid materials can be added, e.g., the aforementioned vinyl ethers such as ethyl vinyl ether or a polyvinyl ether such as ethylene glycol divinyl ether, to permit the further reactions contemplated herein to be carried out. Optionally, any residual alkyl monovinyl ether and simple monohydric alcohol by-product can be retained as a reactive liquid material, but this is usually undesirable since the monohydric alcohol is independently reactive with polyisocyanate and functions as a chain-terminating agent and limits the attainment of the desired molecular weight. Other conventional diluents, e.g., N-vinyl pyrrolidone, N-vinyl caprolactam, and the like can also be present.

The unreacted polyhydric alcohol and partially transvinylated polyhydric alcohol are then converted into a vinyl ether containing oligomer by reaction with the diisocyanate to form a vinyl ether containing oligomer preferably having an average of 1 to 10, more preferably 2 to 5, vinyl ether groups per molecule. The polyisocyanate is utilized in an amount sufficient to substantially eliminate unreacted hydroxy groups present in the transvinylation mixture. Therefore, the isocyanate consumes substantially all of the available hydroxy groups of the transvinylation mixture, i.e., less than about 0.1 percent by weight of hydroxy groups are present in the vinyl ether containing oligomer. Preferably the vinyl ether containing oligomer has a hydroxy number below about 10.

The reaction with organic polyisocyanates increases the number average molecular weight and the vinyl ether functionality of the resultant vinyl ether containing oligomer. This is especially true to the extent that polyhydric alcohols having a hydroxy functionality in excess of 2 are used since this introduces branching or an increase in the number of vinyl ether or divinyl ether groups. While the polyisocyanate can have a functionality higher than two, it is preferred to utilize diisocyanates because of their availability and also because this minimizes the tendency to gel when substantially all of the hydroxy functionality is consumed.

A stoichiometric excess of isocyanate groups, based on hydroxy groups, can be used, but a stoichiometric proportion is preferred. Excess isocyanate groups, when present, can be later consumed by reaction with any isocyanate reactive group. Thus, one can post-react the excess isocyanate groups of the vinyl ether containing oligomer with an alcohol or amine-functional reagent that can be monofunctional or polyfunctional depending upon whether a further increase in molecular weight or functionality is desired.

Any of a wide variety of organic polyisocyanates, alone or in admixture, can be utilized, diisocyanates alone or in admixture with one another preferably constituting all or almost all of this component. Representative diisocyanates include isophorone diisocyanate (IPDI), toluene diisocyanate (TDI), diphenylmethylene diisocyanate, hexamethylene diisocyanate, cyclohexylene diisocyanate, methylene dicyclohexane diisocyanate, 2,2,4-trimethyl hexamethylene diisocyanate, m-phenylene diisocyanate, 4-chloro-1,3-phenylene diisocyanate, 4,4'-biphenylene diisocyanate, 1,5-naphthylene diisocyanate, 1,4-tetramethylene diisocyanate, 1,6-hexamethylene diisocyanate, 1,10-decamethylene diisocyanate, 1,4-cyclohexylene diisocyanate, and polyalkyloxide and polyester glycol diisocyanates such as polytetramethylene ether glycol terminated with TDI and polyethylene adipate terminated with TDI, respectively.

In the reaction between hydroxy and isocyanate groups, it is preferred to employ a stoichiometric balance between hydroxy and isocyanate functionality and to maintain the reactants at an elevated reaction temperature of at least about 40°C. until the isocyanate functionality is substantially consumed. This also indicates the hydroxy functionality is similarly consumed. One can also use a small excess of isocyanate functionality.

Since diisocyanates are preferably used herein, this means that the polyhydric alcohol used should contain a proportion of polyol having at least three hydroxy groups. Using a triol as illustrative, transvinylation provides a monovinyl ether having two hydroxy groups that is reacted with diisocyanates to provide vinyl, ether functionality along the length of the oligomer. Transvinylation also provides a monohydric divinyl ether which acts as a capping agent. Such a capping agent supplies two vinyl ether groups wherever it appears in the vinyl ether containing oligomer. Both of these triol derivatives increase the vinyl ether functionality of the vinyl ether containing oligomers. Moreover, unreacted triol has the same function, for it provides three branches which must be capped by the vinyl ether-containing capping agent.

Further chain extension, and hence increased molecular weight, can be achieved by the addition of conventional chain extenders including amine functional chain extenders. Illustrative amine functional chain extenders include polyoxyalkylene amines and the Jeffamine line of products, commercially available from Jefferson Chemicals.

A monohydric capping agent can also be present to prevent gellation. The use, and amount required, of this agent is conventional.

The internal urethane or urea groups are provided by the stoichiometry of the system. Subtracting the molar proportion of the monohydric capping agent, if such an agent is present, from the number of moles of diisocyanate, the equivalent ratio of hydroxy, and/or amine from the amine functional chain extender if one is utilized, to isocyanate in the unreacted diisocyanate can be about 1:1 and can be up to about 1.2:1. This ratio increases the molecular weight of the vinyl ether containing oligomer and introduces internal urethane or urea groups therein.

Unreacted isocyanate groups can be present in the vinyl ether containing oligomer, but are preferably minimized to less than 0.1 percent by weight. More particularly, the residual isocyanate content of the vinyl ether containing oligomer obtained by reaction of the transvinylation mixture with polyisocyanate can be substantial when further reaction, e.g., reaction with an aforementioned amine functional chain extender, is contemplated, but when the vinyl ether containing

oligomer is to be used for coating, it is preferred that there be no detectable isocyanate present.

The vinyl ether containing oligomer can comprise the reaction product of an organic diisocyanate with a transvinylation mixture containing hydroxy groups that is the transvinylation reaction product of a divinyl ether having the Formula III, above, and at least one aliphatic polyhydric alcohol having an average of 3 or more hydroxy groups per molecule. The diisocyanate consumes substantially all of the available hydroxy groups of the transvinylation mixture. The equivalent ratio of vinyl ether to polyhydric alcohol is in the range of 0.5:1 to 5:1.

Further examples of suitable vinyl ether containing oligomers are polyvinyl ether polyurethanes and saturated polyesters such as those shown in U.S. Patent Nos. 4,472,019, 4,749,807, 4,751,273, and 4,775,732.

Further representative vinyl ether containing oligomers are obtained by the metathesis of a cyclic olefin ether having the following general Formula IV:

(IV) 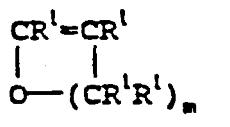

wherein each $R^I$ individually can be hydrogen, an alkyl, aryl, cycloaliphatic or halogen group and m is a number in the range of 2 to 10, preferably 5 to 6. Metathesis, which is described in March, Advanced Organic Chemistry, Third Edition, copyright 1985 by John Wiley & Sons, Inc., pp 1036-1039 & 1115, results in the opening of the ring of the cyclic olefin ether to produce a vinyl ether containing oligomer having the following general Formula V:

$$Z\{(CR^IR^I)_m\text{-O-}CR^I{=}CR^I\}_yZ \qquad (V)$$

wherein $R^I$ and m are as previously described, y is a number in the range of 2 to 50, preferably 2 to 25, and each Z is an end group; e.g., hydrogen, a vinyl group. The vinyl ether containing oligomers of Formula V can be blended with the other vinyl ether containing oligomers of the present invention or those disclosed in U.S. Patent Nos. 4,472,019, 4,749,807, 4,751,273, and 4,775,732.

The oligomers having an average of at least one vinyl ether ethylenically unsaturated group per of oligomer preferably contain an average of 1 to 10, more preferably 2 to 5, vinyl ether groups per molecule of oligomer.

The number average molecular weight of the oligomers having an average of at least one vinyl ether group per molecule of oligomer is preferably 500 to 8,000, more preferably 1,000 to 4,000, daltons.

When the compositions of the present invention are utilized as a primary coating for optical glass fiber the equivalent weight of the oligomers having an average of at least one vinyl ether group per molecule of oligomer is preferably 500 to 1,500, more preferably 800 to 1,200.

When the compositions of the present invention are utilized as a secondary coating for optical glass fiber the equivalent weight of the oligomers having an average of at least one vinyl ether group per molecule of oligomer is preferably 300 to 1,000, more preferably 400 to 800.

The single functionality diluents suitable for use herein include vinyl ether diluents, vinyl amides, divinyl ethers, ethylenically unsaturated monocarboxylates and dicarboxylates that are not acrylates, the like and mixtures thereof.

Representative of the single functionality diluents are N-vinyl pyrrolidinone, N-vinyl imidazole, 2-vinylpyridine, N-vinyl carbazole, N-vinyl carprolactam, the like, and mixtures thereof.

Representative of other single functional diluents are the divinyl ethers of triethylene glycol or of any other diol, such as 1,6-hexane diol or dibutylene glycol. One may also use polyvinylates of other polyhydric alcohols, such as glycerin or trimethylol propane. Polyhydric polyethers can be used, such as ethylene oxide, propylene oxide or butylene oxide adducts of polyhydric alcohols, illustrated by ethylene glycol, butylene glycol, glycerin, trimethylol propane or pentaerythritol.

Preferred single functionality diluents are triethylene glycol divinyl ether commercially available from GAF under the trade designation Rapicure DVE-3, butane diol divinyl ether, 1,4-cyclohexane dimethanol divinyl ether, octyl vinyl ether, diethyl furmarate, diethyl maleate, dimethyl maleate, the like, and mixtures thereof.

The single functionality diluent, including admixtures thereof, is preferably selected, i.e., both the type of reactive group(s) of the single functionality diluent(s) and the amount utilized are chosen to provide in the composition a ratio of vinyl ether double bonds to electron deficient dicarboxylate double bonds ratio of 5:1 to 1:5, preferably 2:1 to 1:2. Most preferably this ratio is about 1:1

The single functionality diluents can have an average of 1 to 4, preferably 1 to 3, reactive groups per molecule.

The saturated polyester having electron deficient unsaturated end groups is the reaction product of a saturated polyester backbone containing component and an electron deficient ethylenically unsaturated end group containing component.

The saturated polyester backbone containing component can be represented by hydroxy functional saturated

dicarboxylates, polycarbonates, polycaprolactones and the like.

The hydroxy functional saturated dicarboxylates can be the reaction product of an aforementioned saturated dicarboxylic acid and an aforementioned polyhydric alcohol.

Commercially available polycarbonates include the aforementioned Duracarb products commercially available from PPG industries and Duracarb 124 also commercially available from PPG Industries.

Commercially available polycaprolactones include the aforementioned Tone Polyol series of products commercially available from Union Carbide.

The saturated polyester backbone containing component is reacted with an ethylenically unsaturated group containing component that can be the reaction product of an ethylenically unsaturated dicarboxylic acid, or anhydride, and a monohydric alcohol or a previously discussed cyclic ether.

Representative of the monohydric alcohols are the $C_1$ to $C_{10}$ alcohols, e.g., ethanol, decanol, the like and mixtures thereof.

Representative unsaturated dicarboxylic acids and anhydrides are maleic acid, maleic anhydride, fumaric acid, and itaconic acid.

If the ester produced by the reaction of the dicarboxylic acid, or anhydride, and the alcohol, or cyclic ether, has unreacted carboxyl groups, this ester can be conventionally reacted with a material having a group that is reactive with the carboxyl groups of the ester, e.g., hydroxy groups and epoxy groups.
Preferably, this material is resinous and has a number average molecular weight of 300 to 5,000, more preferably 500 to 2,500 daltons.

The saturated polyester having electron deficient unsaturated dicarboxylate end groups preferably has an average of 1 to 10, more preferably 2 to 5, electron deficient ethylenically unsaturated dicarboxylate end groups per molecule of saturated polyester having electron deficient unsaturated dicarboxylate end groups.

The equivalent weight of the saturated polyester having electron deficient unsaturated dicarboxylate end groups is preferably about 100 to about 10,000, more preferably about 200 to about 1,000.

The present invention is directed to dual functional monomers and the use of these dual functional monomers in compositions including the compositions of the present invention. The dual functional monomers can be utilized in place of, or with, the single functionality diluents in the compositions of the present invention. The dual functional monomers can be represented by the following Formula I:

(I) 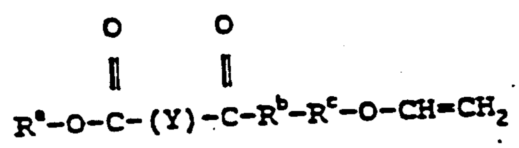

wherein $R^a$ is selected from the group consisting of H, $C_1$ to $C_{10}$ alkyl or allyl groups, $C_5$ to $C_{10}$ aryl groups, metal ions, heteroatoms and a combination of carbon and heteroatoms; $R^b$ is absent or selected from the group consisting of $C(R^a)_2$, heteroatoms or substituted heteroatoms; $R^c$ is an aliphatic, branched or cyclic alkyl group or an arylalkyl group that contains 1 to 10 carbon atoms, and can contain heteroatoms; and Y is selected from the group consisting of:

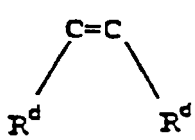 ; 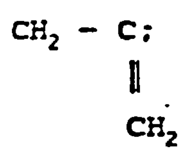 ; 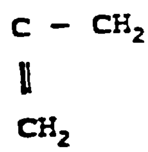 ; and 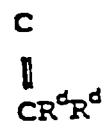

wherein each $R^d$ is independently selected from the group consisting of H, $C_1$ to $C_4$ alkyl groups; $C_5$ to $C_{10}$ aryl groups and electron withdrawing groups.

Preferably, $R^a$ is a $C_1$ to $C_4$ alkyl group, $R^b$ is O, $R^c$ is a $C_2$ to $C_8$ alkyl group and each $R^d$ is H.

The heteroatoms that can be present in the dual functional monomer include non-carbon atoms such as oxygen, nitrogen, sulfur, silicon, phosphorus and the like.

Representative of electron withdrawing groups are CN, $SO_2$, $SO_3$, $CONH_2$, Cl, $CO_2$ and the like.

The dual functional monomer can homopolymerize in the presence of conventional free-radical initiators. Alternatively, the dual functional monomer can be utilized in compositions that include other monomers and oligomers to produce alternating copolymers and random copolymers.

The present compositions preferably contain the oligomer having an average of at least one vinyl ether group per molecule of oligomer in an amount in the range of about 0 to about 80, more preferably about 20 to about 70, weight percent based on the total weight of the composition.

The present compositions preferably contain the saturated polyester having electron deficient unsaturated dicarboxylate end groups in an amount in the range of 0 to 80, more preferably 20 to 70, weight percent based on the total weight of the composition.

The present compositions preferably contain the single functionality diluent in an amount in the range of 0 to 40, more preferably 25 to 35, weight percent based on the total weight of the composition.

The present compositions preferably contain the dual functional monomer in an amount in the range of about 0 to 40, more preferably 5 to 30, weight percent based on the total weight of the composition.

The viscosity of the present compositions at a temperature of 25°C is preferably about 50 to about 25,000, more preferably about 50 to about 15,000, centipoise (cP) and is adjusted to enhance the use of the compositions.

The compositions of the present invention are preferably solvent free.

The dual functional monomer and compositions of the present invention can be cured upon exposure to energy such as ionizing radiation, actinic energy, i.e., ultraviolet and visible light, and heat, i.e., thermal cure.

Conventional ionizing radiation sources include electron beam devices. The amount of ionizing radiation required for cure of a 3 mil thick film is 1 to 5 megarads.

When cure of the dual functional monomer or compositions of the present invention is by exposure to actinic energy of appropriate wavelength, much as ultraviolet light, a photoinitiator can be admixed with the monomer or composition. It is desirable to select the photoinitiator from the group consisting of (1) hydroxy- or alkoxy-functional acetophenone derivatives, preferably hydroxyalkyl phenones, or (2) benzoyl diaryl phosphine oxides. Materials having the two different types of ethylenically unsaturation, i.e., the vinyl ether group and the ethylenically unsaturated group, copolymerize rapidly in the presence of the specified groups of photoinitiators to provide a rapid photocure and also interact rapidly upon exposure to other types of energy when no polymerization initiator is present.

Ethylenically unsaturated dicarboxylates respond poorly to photocure using, for example, ultraviolet light when the photoinitiator is an ordinary aryl ketone photoinitiator, such as benzophenone. Also, vinyl ethers do not exhibit any substantial curing response to ultraviolet light when these aryl ketone photoinitiators are utilized. Nonetheless, these two types of ethylenically unsaturated atoms in admixture respond to the photocure very rapidly when the photoinitiator is correctly selected. The photocure, and the cure upon exposure to other types of energy when no initiator is present, is especially rapid and effective when both of the described types of unsaturation are provided in polyfunctional compounds, particularly those of resinous character. The fastest cures are obtained when the respective functionalities are present in about the same equivalent amount.

Preferably the photoinitiators are (1) hydroxy-or alkoxy-functional acetophenone derivatives, more preferably hydroxyalkyl phenones, and (2) benzoyl diaryl phosphine oxides.

The acetophenone derivatives that may be used have the Formula VI:

(VI)

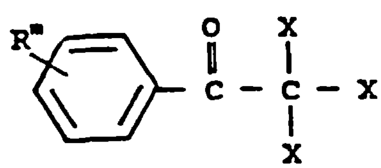

in which $R^m$ is an optional hydrocarbon substituent containing from 1 to 10 carbon atoms and which may be alkyl or aryl, e.g., methyl, ethyl, butyl, octyl or phenyl, X is selected from the group consisting of hydroxy, $C_1$ to $C_4$ alkoxy, $C_1$ to $C_8$ alkyl, cycloalkyl, halogen, and phenyl, or 2 Xs together are cycloalkyl, and at least one X is selected from the group consisting of hydroxy and $C_1$ to $C_4$ alkoxy.

Many compounds have the required structure. The alkoxy groups are preferably methoxy or ethoxy, the alkyl group is preferably methyl or ethyl, the cycloalkyl group is preferably cyclohexyl, and the halogen is preferably chlorine. One commercially available compound is the Ciba-Geigy product Irgacure 651 which has the Formula VII:

(VII)

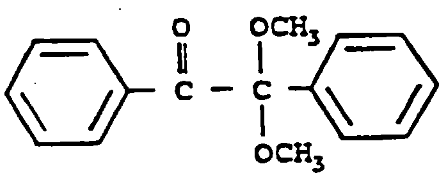

Irgacure 184, also from Ciba-Geigy, is another useful acetophenone derivative, and it has the Formula VIII:

(VIII)

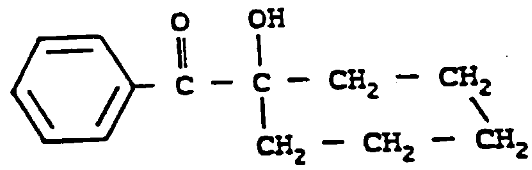

Still another commercially available useful acetophenone derivative is diethoxy acetophenone, available from Upjohn Chemicals, North Haven, CT, which has the Formula IX:

(IX)

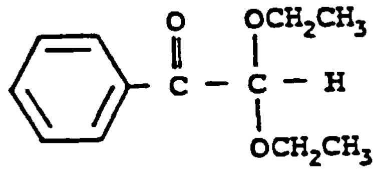

When the photoinitiator is a hydroxy-functional compound, one can define the useful acetophenone derivatives in a somewhat different manner. Thus, the hydroxyalkyl phenones which are preferred herein have the Formula X:

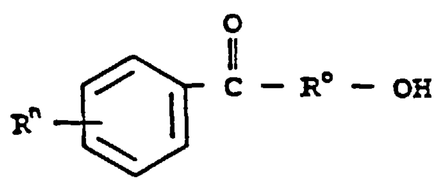

(X)

in which $R^o$ is an alkylene group containing from 2-8 carbon atoms and $R^n$ is an optional hydrocarbon substituent containing from 1 to 10 carbon atoms and which may be alkyl or aryl, e.g., methyl, ethyl, butyl, octyl or phenyl.

It is particularly preferred that the hydroxy group be in the 2-position in which case it is preferably a tertiary hydroxy group which defines a hydroxy group carried by a carbon atom that has its remaining three valences connected to other carbon atoms. Particularly preferred compounds have the Formula XI:

(XI)

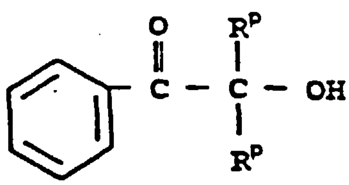

in which each $R^p$ is independently an alkyl group containing from 1 to 4 carbon atoms. In the commercial product Darocur 1173 (available from E-M Company, Hawthorne, N.Y.), each $R^p$ is methyl. This provides a compound which can be described as 2-hydroxy-2-methyl-1-phenyl propane 1-one. The "propane" is replaced by butane or hexane to describe the corresponding compounds, and these will further illustrate preferred compounds in this invention.

The benzoyl diaryl phosphine oxide photoinitiators which may be used herein have the Formula XII:

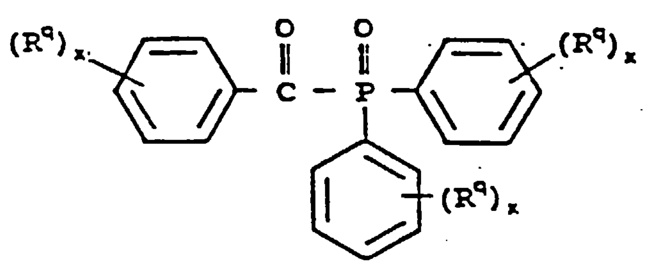

(XII)

In Formula XII, $R^q$ is an optional hydrocarbon substituent containing from 1 to 10 carbon atoms and may be alkyl or aryl as previously noted, and each x is independently an integer from 1 to 3. In preferred practice, a 2,4,6-trimethyl benzoyl compound is used, and the two aromatic groups connected to the phosphorus atom are phenyl groups. This provides the compound 2,4,6-trimethyl benzoyl diphenyl phosphine oxide which is available from BASF under the trade designation Lucirin TPO.

When utilized, the photoinitiator is preferably present in an amount in the range of 0.01 to 10.0, more preferably 0.1 to 6.0, weight percent based on the total weight of the composition.

Suitable sources of actinic energy include lasers and other conventional light sources having an effective energy output, e.g., mercury lamps.

The wavelength of the actinic energy extends from the ultraviolet range, through the visible light range and into the infrared range. Preferred wavelengths are 200 to 2,000, more preferably 250 to 1,000, nanometers (nm).

The amount of actinic energy utilized to solidify a 3 mil thick film is 0.05 to 5.0, preferably 0.1 to 1, Joules per square centimeter (J/sqcm).

The monomers and compositions also can be thermally cured in the presence of a conventional thermal free-radical initiator, e.g., benzoyl peroxide, cyclohexanone peroxide N,$N^1$-azobis(isobutyrylnitrite), metallic dryer systems, redox systems, and the like.

The free-radical curable monomers and compositions of the present invention can be utilized, as coatings (especially as primary and secondary optic glass fiber coatings), in a metallization process wherein a non-metallic substrate is provided with a metal finish, to produce objects utilizing an optical fabrication process as described in U.S. Patent No. 4,575,330 to Hull, in composite materials and other applications.

The following Examples are present by way of representation, and not limitation, of the present invention.

EXAMPLE 1: <u>Preparation of the Dual Functional Monomer</u>

Into a one liter 4-neck flask were introduced 298.3 grams (g) (1.732 equivalents) of diethylmaleate, commercially available from Aldrich Chemical Co., Milwaukee, WI, 201.2 g (1.732 equivalents) of 4-hydroxybutyl vinyl ether (HBVE), commercially available from GAF under the trade designation Rapicure HBVE, 0.5 g of tetraoctyl titanate, a conventional esterification cataylst commercially available from DuPont under the trade designation TYZOR TOT, and 0.22 g of phenothiazine, a conventional inhibitor commercially available from ICI Chemicals, Wilmington, DE. The flask was fitted with a variable speed stirrer, thermometers, a snyder column, a condenser with a trap, a nitrogen sparge and a heating mantle.

The temperature of the contents of the flask and the temperature at the top of the column, i.e., a thermometer is placed in the condenser at the top of the column to measure the temperature of distillate, were set to distill about 80 g of ethanol in a time period of about 2.5 hours. The resultant product was a liquid having a viscosity at 25°C. of about 36 centipoise (cP).

Oligomer 2: <u>Preparation of a Vinyl Ether Containing Oligomer</u>

A 1 liter 4-neck flask was fitted with a variable speed stirrer, a heating mantle or ice water bath as needed, a dry air sparge and an addition funnel. The flask was charged with 95.25 g of 2,2,4-trimethyl hexane diisocyanate having a nitrogen-carbon-oxygen group content (NCO) of 39.68%, 41.5 g diethyl maleate as a single functionality diluent which also serves as a solvent in the preparation of this vinyl ether containing oligomer, 0.1 g of phenothiazine and 0.25 g dibutyl tin dilaurate. The contents of the flask were then heated to a temperature of 40°C. The funnel was then charged with 29.9 g of HBVE. The HBVE was slowly introduced into the flask over a time period of about one hour and the contents of the flask were maintained at that temperature for about one hour. Thereafter, 316.5 g of Tone 0221 were slowly added to the flask and the temperature of the contents of the flask maintained at about 70°C. for a time period of about 6 hours. Substantially all of the isocyanate functionality (NCO) was consumed. The percent NCO of the oligomer produced was about 0.02%. This oligomer had a theoretical molecular weight of about 3450 and a viscosity at 25°C. of 54,000 cP.

Oligomer 3: <u>Preparation of a Vinyl Ether Containing Oligomer</u>

A 2 liter 4-neck flask was fitted in a manner similar to the 1 liter flask of EXAMPLE 2. The flask was charged with 334.76 g (2.9809 equivalents) of IPDI and 0.5 g of dibutyltin dilaurate. The addition funnel was charged with 115.74 g (0.9964 equivalents) of HBVE. The stirrer was set at about 200 rpm, the sparge was activated and the ice water bath was utilized to maintain the contents of the flask at a temperature in the range of about 25°C. to about 30°C. The HBVE was slowly introduced into the flask over a time period of about 50 minutes. The contents of the flask were maintained in this temperature range for a time period of about 5 hours and then the temperature was raised to about 40°C. The addition funnel was then charged with 574.9 g (1.9924 equivalents) of Tone Polyol 2201. The Tone was introduced into

the flask over a time period of about 20 minutes. The contents of the flask were maintained at a temperature of about 70°C. for a time period sufficient to consume substantially all of the remaining isocyanate functionality. The resulting oligomeric product had a viscosity of about 3,700,000 cP at a temperature of 25°C. and a theoretical molecular weight of about 2,000 daltons.

EXAMPLE 5: Compositions

A composition utilizing the product of EXAMPLE 1 and other components was prepared. The formulations of the compositions are provided in TABLE I, below. The composition A is particularly well suited for use as primary coatings for optical glass fiber.

TABLE I

| COMPOSITIONS | |
|---|---|
| Component | Composition |
| | A(wt%)[1] |
| Example 1[2] | 13.9 |
| Example 2[3] | 83.2 |
| Example 3[4] | --- |
| Example 4[5] | --- |
| Diethyl Maleate | --- |
| Rapicure DVE-3[6] | --- |
| Phenothiazine[7] | 0.1 |
| Lucirin TPO[8] | 2.9 |
| Irgacure 184[9] | --- |
| Darocur 1173[10] | --- |

[1] Weight percent.
[2] The dual functional monomer of Example 1.
[3] The vinyl ether containing oligomer
[7] An inhibitor.
[8] The photoinitiator 2,4,6,trimethylbenzoyldiphenylphosphine oxide is commercially available from BASF.

The results of tests conducted on composition A and coatings produced therefrom are presented in TABLE II. Test results are also provied for two commerically available compositions E and F. The test procedures follow Table II.

TABLE II

| TEST RESULTS | | | |
|---|---|---|---|
| Property | | Compositions | |
| | A | Conventional[1] | |
| | | E | F |
| Viscosity, Pa • s | NA[2] | 4.2 | 12.5 |
| Cure Dose, J/sqcm | <1.0 | 1.2 | 1.0 |
| Tensile Properties | | | |
| Tensile, MPa | 2.7 | 0.4 | 1.4 |
| Elongation, | 69 | 110 | 80 |
| Modulus, MPa | 3.0 | 1.3 | 2.0 |
| Water Resistance | | | |
| % Water Absorp. | 0.4 | 0.5 | 2.0 |
| % Extractables | -2.2 | -0.5 | -2.0 |
| $H_2$ Generation, µl/g | 0.5 | 1.1 | 0.4 |
| Glass Transition Temp. (°C) | -27 | -35 | -12 |

[1]Compositions E and F are commercially available from Dainippon Ink Co. and ICI, respectively, and are acrylate containing primary optical glass fiber coating compositions.
[2]Not available

Viscosity

The viscosity, expressed in pascal seconds (Pa • s), was measured using a Brookfield Model RVTD viscometer operated in accordance with the instructions provided therewith. The temperature of each sample tested was 25°C.

Cure Dose

The cure dose is the dosage required to achieve 95% of the ultimate modulus. A cure dose of 1.0 J/sqcm or less is desirable.

Tensile Properties

A film for determination of the tensile properties, i.e., tensile strength Megapascals (MPa), percent elongation at break (%) and modulus (MPa), expressed in, of the coating was prepared by drawing down a 3 mil coating on glass plates using a Bird bar, commercially available from Pacific Scientific, Silver Springs, MD. An automatic draw down apparatus like a Gardner AG-3860 commercially available from Pacific Scientific, Gardner/Neotec Instrument Division, Silver Springs, MD, can be utilized. The coating was cured using a "D" lamp from Fusion Curing Systems, Rockville, MD. The "D" lamp emits radiation having a wavelength of about 200 to about 470 nanometers with the peak radiation being at about 380 nanometers and the power output thereof is about 300 watts per linear inch. The coating was cured at a dose of about 1 J/sqcm which provided complete cure. The film was then conditioned at 23 ± 2°C. and 50 ± 3% relative humidity for a minimum time period of 16 hours.

Six, 0.5 inch wide test specimens were cut from the film parallel to the direction of the draw down and removed from the glass plate. Triplicate measurements of the dimensions of each specimen were taken and the average utilized. The tensile properties of these specimens were then determined using an Instron Model 4201 from Instron Corp., Canton, MA operated in accordance with the instructions provided therewith.

Water Resistance

To determine the water resistance a 10 mil draw-down of the composition was made on a glass plate utilizing a Bird

bar. The composition was cured utilizing the "D" lamp at a dose of 1.0 J/sqcm. Three test samples each having dimensions of 1/2" x 1" x 1/2" were cut from the cured coating. Each sample was weighed utilizing an analytical balance to obtain weight measurement A and then immersed in separate containers of deionized water. After a time period of 24 hours, the samples were removed from the water, blotted to remove excess water on the surface and reweighed to obtain weight measurement B. The samples were then placed in aluminum pans and maintained therein at ambient conditions, i.e., ambient temperature (about 20° - 30°C.) and ambient humidity, for a time period of 120 hours. The samples were then reweighed to obtain weight measurement C. The following equations were utilized to calculate the water absorption and the extractables.

$$\% \text{ water absorption} = [(B - A)/A] \times 100 \quad (I)$$

$$\% \text{ extractables} = [(C - A)/A] \times 100 \quad (II)$$

It is preferably to have relatively low % water absorption and % extractables.

Hydrogen ($H_2$) Generation

Cured films for determination of the hydrogen generation of the composition were prepared by drawing down a 10 mil coating on glass plates using a Bird bar, commercially available from Pacific Scientific, Silver Springs, MD. The film was cured using the "D" lamp. The coating was cured at a dose of about 1 J/sqcm which provided complete cure.

Eight grams, measured to the nearest 0.01 gm, of the cured film were placed in a dry 100 ml bottle. The bottle was then purged with an inert gas and immediately sealed with a septum and seal. The sealed bottle was then placed in an air circulating oven having a temperature of 80° ± 2°C and maintained therein for a time period of 24 hours. After 24 hours, the bottle was removed from the oven and cooled to room temperature. An air sample was removed from the bottle utilizing a syringe. Twenty ml of the air sample were introduced into a calibrated Key-Med Exhaled Hydrogen Monitor and the hydrogen concentration read in parts per million (ppm) from the readout of the monitor. The microliters/gram (μl/g) of hydrogen generated was determined utilizing the following equation:

$$\mu l/g = \frac{[H_2]\,(0.120)}{g \text{ cured coating}}$$

wherein: $H_2$ is the hydrogen concentration in ppm; 0.120 is the conversion factor to convert ppm hydrogen in the bottle into μl of hydrogen evolved from the sample; and gm cured coating is the gm of the cured film placed in the bottle.

A relatively low hydrogen generation is desirable as hydrogen can interfere with the performance of the fiber by increasing tramsmission loss.

Glass Transition Temperature

The glass transition temperature was determined by dynamic mechanical analysis.

As the test results indicate, optical glass fiber coatings prepared from the compositions of the present invention have properties that are comparable to the properties of optical glass fiber coatings produced from commercially available compositions. Furthermore, the compositions of the present invention do not utilize acrylate or methacrylate diluents and therefore have a lower toxicity than compositions containing these acrylate or methacrylate diluents.

EXAMPLE 7: Coating Compositions for Vulcanized Rubber

Compositions of the present invention suitable as coatings for vulcanized rubber were prepared and tested. The compositions utilized the vinyl ether containing oligomer 3 and composition L also utilized the dual functional monomer of EXAMPLE 1. The formulations of the compositions are presented in TABLE V. Composition K is not according this invention.

TABLE V

| Component | Coating Compositions For Vulcanized Rubber | |
|---|---|---|
| | Composition (wt%): K | L |
| Vinyl Ether Containing Oligomer[1] | 82.9 | 79.4 |
| Diethyl Maleate | 14.1 | 13.5 |
| Monomer[2] | --- | 4.0 |
| Lucirin TPO | 2.9 | --- |
| Irgacure 184 | --- | 2.9 |
| Phenothiazine | 0.1 | 0.2 |

[1] The vinyl ether containing oligomer 3.
[2] The dual functional monomer of EXAMPLE 1.

The test results are provided in Table VI.

TABLE VI

| Property | Test Results | |
|---|---|---|
| | Composition: K | L |
| Cure dose (J/sqcm) | 1 | 1 |
| Surface condition | Tacky | Slight tack |
| Viscosity (cP) | High | 20,000 |
| Adhesion : 610 | Good | Good |
| Elongation (%) | 153 | 80 |

All coatings were prepared by drawing down a film on a styrene-butadiene rubber substrate and the film was cured. The test procedures for cure dose, viscosity and elongation have been discussed.

<u>Adhesion : 610</u>

The adhesive surface of Scotch brand 610 tape, commercially available from 3M Company, was adhered to the film. The tape was then pulled from the film and a qualitative analysis of how well the film adhered to the substrate was made.

## Claims

1. A dual functional monomer having the Formula:

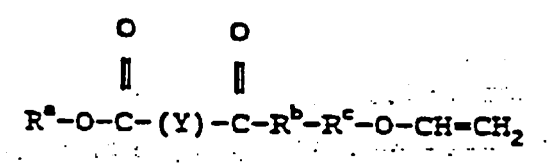

wherein $R^a$ is selected from the group consisting of H, $C_1$ to $C_{10}$ alkyl or allyl groups, $C_5$ to $C_{10}$ aryl group, metal ions, heteroatoms and combinations of carbon and heteroatoms; $R^b$ is absent or selected from the group consisting of O, $C(R^a)_2$, heteroatoms, or substituted heteroatoms; $R^c$ is an aliphatic, branched or cyclic alkyl group or an arylalkyl group that contains 1 to about 10 carbon atoms, and can contain heteroatoms; and Y is selected from the

group consisting of:

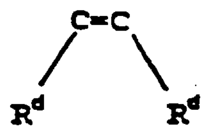 ; 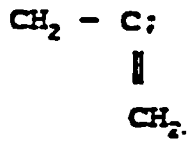 ; 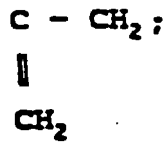 ; and 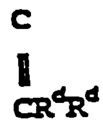

wherein each $R^d$ is independently selected from the group consisting of H, $C_1$ to $C_4$ alkyl groups, $C_5$ to $C_{10}$ aryl groups and electron withdrawing groups.

**2.** The dual functional monomers in accordance with claim 28 wherein $R^a$ is a $C_1$ to $C_4$ alkyl group, $R^b$ is O, $R^c$ is a $C_2$ to $C_8$ alkyl group and each $R^a$ is H.

European Patent Office

# EUROPEAN SEARCH REPORT

Application Number
EP 97 20 1941

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | DATABASE WPI<br>Week 7342<br>Derwent Publications Ltd., London, GB;<br>AN 73-62474U<br>XP002040780<br>& JP 48 014 615 A (NIOD)<br>* abstract *<br>----- | 1 | C07C69/60<br>C07C69/593 |

TECHNICAL FIELDS SEARCHED (Int.Cl.6)
C07C

The present search report has been drawn up for all claims

| Place of search | Date of completion of the search | Examiner |
|---|---|---|
| THE HAGUE | 16 September 1997 | Kinzinger, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)